Europäisches Patentamt

European Patent Office

Office européen des brevets

(19)

(11) **EP 1 097 388 B1**

(12) **EUROPEAN PATENT SPECIFICATION**

(45) Date of publication and mention
of the grant of the patent:
**06.05.2004  Bulletin 2004/19**

(21) Application number: **99937990.2**

(22) Date of filing: **03.03.1999**

(51) Int Cl.$^7$: **G01R 31/36**

(86) International application number:
**PCT/GB1999/000639**

(87) International publication number:
**WO 1999/045404 (10.09.1999 Gazette 1999/36)**

(54) **METHOD OF AND APPARATUS FOR ESTIMATING THE CHARGE IN A BATTERY**

VERFAHREN UND VORRICHTUNG ZUR ABSCHÄTZUNG DES LADEZUSTANDES EINES
AKKUMULATORS

PROCEDE ET APPAREIL PERMETTANT D'ESTIMER LA CHARGE D'UNE BATTERIE

(84) Designated Contracting States:
**DE ES FR GB IT SE**

(30) Priority: **05.03.1998  GB 9804684**

(43) Date of publication of application:
**09.05.2001  Bulletin 2001/19**

(73) Proprietor: **LUCAS INDUSTRIES public limited
company
London W1Y 4DJ (GB)**

(72) Inventor: **RENNISON, John, Henry
Birmingham B28 0TN (GB)**

(74) Representative: **Beck, Simon Antony et al
Withers & Rogers
Goldings House
2 Hays Lane
London SE1 2HW (GB)**

(56) References cited:
**EP-A- 0 613 203          WO-A-98/22830
US-A- 5 381 096**

- **CARPENTER M K ET AL: "The use of Hg/Hg2SO4
reference electrodes in valve-regulated
lead/acid cells" JOURNAL OF POWER
SOURCES, vol. 63, no. 1, 1 November 1996, page
15-22 XP004071522**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

Printed by Jouve, 75001 PARIS (FR)

**Description**

The present invention relates to a method of and an apparatus for measuring the charge in a chargeable battery.

Automobiles have ever increasing electrical loads therein, such as air conditioning, fans, rear demist, radios and mobile telephones and may soon implement electrically assisted power steering. Furthermore, security systems have increased the quiescent drain on a battery during those times when the automobile is parked. Furthermore, increasing traffic levels mean that the automobile can spend a considerable portion of its time at idle, when the vehicle's alternator produces relatively little charging current. In fact, the battery may be discharging when the engine is idling due to the presence of loads, such as lighting and demisters.

Systems for estimating the state of charge of a battery are known. Those which cope with both charging and discharging are generally based on a current integration method in which the current flow is integrated with respect to time in order to determine how much charge is left in the battery. However these devices are prone to error since small errors in the current measurement can become integrated up to large errors. Furthermore, in an automobile system the current integrator may adequately need to resolve quiescent currents in the range of 5 mA, and yet still measure cranking currents in the range of 200 Amps or more. This large dynamic range causes current integrator based systems to be inherently unreliable.

EP 613203 discloses a device for displaying the charge in a rechargeable cell. The voltage across the cell is measured whilst a known current is supplied to the cell.

US 5,381,096 describes a system in which a state of charge is estimated by measuring the terminal voltage and comparing this with a model of the battery.

WO98/22830 also discloses an apparatus where an estimate of a battery state of charge is derived by measuring the terminal voltage of a battery and providing it to a model of the battery.

Carpenter et al "The use of $Hg/Hg_2SO_4$ reference electrode in valve regulated lead/acid cells", Journal of Power Sources 63 (1996) 15-22 discloses the inclusion of a reference electrode within a battery to help with characterising the battery state of the charge.

According to a first aspect of the present invention there is provided a method of monitoring the state of charge of a battery, comprising monitoring the potential difference across a battery, and estimating the charge of the battery, characterised in that the data processor is arranged to perform a hysteresis correction which calculates a correction to the measured battery terminal voltage as a function of a estimate of an equilibrium voltage for the battery and an estimate of a state of charge of the battery.

Preferably the battery is represented as at least first, second and third storage regions having first, second and third charge storage capacities, respectively, and wherein charge can be exchanged between the first and second regions via a first exchange path, and between the second and third regions via a second exchange path, the first and second exchange paths exhibiting respective impedances to the exchange of charge between the regions.

Preferably the first storage region is the smallest storage region. The first storage region represents the region closest to the battery terminals. Additionally a terminal exchange path may be included between the first storage region and the battery terminals.

Preferably each exchange path has at least one associated exchange coefficient that indicates the ease with which charge can be exchanged along the exchange path. Thus, if the model is considered to represent the charges in the regions as voltages in storage devices, such as capacitors, then the exchange coefficients represent the effective ohmic impedance between the storage devices. If, in a further analogy, the storage regions are represented by liquid levels in tanks, then the exchange coefficients may represent the permeability of membranes dividing the tanks from one another or may represent the cross section area of pipes or orifices connecting the tanks.

The charge exchange rate may be represented by an appropriate exchange coefficient and a function of a first parameter, such as the charge stored in the charge store (which may be corrected by a further coefficient representing a property of the charge store, such as capacitance or base area), voltage on the storage device or liquid level in the tank. Preferably, the charge exchange rate is a non-linear function of the difference in the first parameter between connected tanks. Advantageously the non-linear function is a square of the difference.

Preferably different coefficients may be provided for different directions of charge flow between the storage regions.

The model incorporates a hysteresis correction. The charge stored in a lead-acid battery is approximately proportional to the equilibrium (ie settled) voltage of the battery. When a discharged battery is partially charged, and then left open circuit, the terminal voltage does not completely settle to a value which is proportional to the charge stored. Similarly, when a charged battery is partially discharged and then left open circuit, the terminal voltage does not completely recover to a value which is proportional to the charge stored. The hysteresis correction defines a band, whose width may vary with state of charge, to account for this uncertainty in battery terminal voltage.

The model may also include a charge acceptance correction which may account for the fact that the charging efficiency of a battery decreases as it's state of charge approaches full capacity and/or the ability of a recently discharged battery to accept charge is greater than a similar battery at a similar state of charge, but which has been left standing for a while.

Preferably the battery being modelled is a lead-acid battery, although it is expected that the model can be adapted to other rechargeable battery technologies.

According to a second aspect of the present invention, there is provided an apparatus for monitoring the state of charge of a battery, comprising voltage monitoring means for monitoring the potential difference across a battery, and processing means responsive to the measurement of voltage for estimating the charge of the battery, characterised in that the data processor is arranged to perform a hysteresis correction which calculates a correction to the measured battery terminal voltage as a function of an estimate of an equilibrium voltage for the battery and an estimate of a state of charge of the battery.

Advantageously the battery monitoring apparatus further comprises a load controller arranged to disconnect or restrict power consumed by one or more loads in order to maintain the battery charge above a predetermined threshold, and/or to vary the engine idle speed in order to increase the alternator output. Additionally or alternatively, the alternator may have a variable drive ratio in order to increase its output during idle. A supplementary source of electrical power could be switched on by the battery monitor when required, such as an additional generator, an additional battery or a battery charger.

The present invention will further be described, by way of example, with reference to the accompanying drawings, in which:

Figure 1 schematically illustrates a model for a lead acid battery;

Figure 2 shows a flow chart for controlling operation of the battery model;

Figure 3 is a flow chart of an initialisation routine for the model;

Figures 4, 5, 6, 7, 8 and 9 are flow charts for the battery model;

Figure 10 is a graph of hysteresis limits versus state of charge;

Figure 11 is a graph of gassing voltage correction versus uncompensated voltage;

Figure 12 is a graph of permeability multiplier versus state of charge;

Figure 13 is a schematic diagram of a automobile electrical system;

Figure 14 is a graph showing measured currents and estimated currents for a battery on a test rig;

Figure 15 compares the state of charge of a battery as estimated by a model constituting an embodiment of the present invention versus state of charge as measured by a testing rig using current integration techniques; and

Figure 16 is a graph of battery resistance versus charge levels.

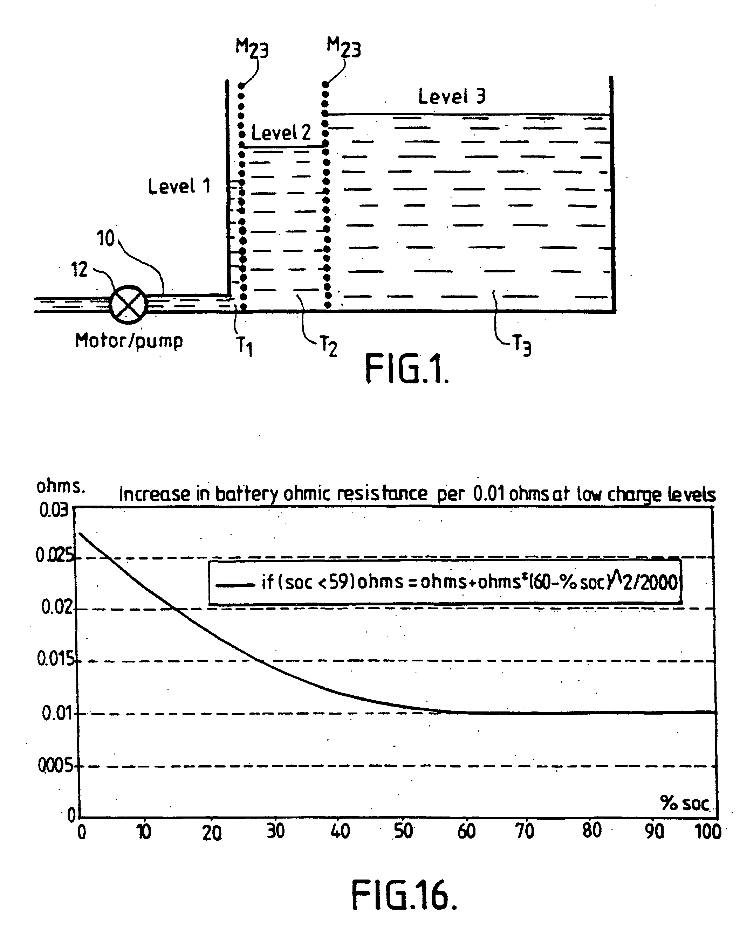

Figure 1 schematically illustrates one embodiment of the battery model wherein the battery is represented by three tanks $T_1$, $T_2$ and $T_3$. The first and second tanks $T_1$ and $T_2$ are separated by a permeable membrane $M_{12}$, and the second and third tanks are separated by a permeable membrane $M_{23}$. The tanks are of different sizes. The first tank $T_1$ is the smallest, the second $T_2$ is an intermediate size, and the third tank $T_3$ is the largest. The relative areas of the tanks, $A_1$, $A_2$ and $A_3$, respectively, are typically 1%, 20% and 79% of an effective total area, respectively. The liquid level in each tank is taken to represent the effective voltage of the storage region represented by the tank. Thus the level of tank 1 can be measured at the output terminal of the battery. The relative levels of tanks 1, 2 and 3 govern the rate of liquid transfer between tanks 1 and 2, and 2 and 3. The total volume of liquid in tanks $T_1$, $T_2$ and $T_3$ represents the charge stored in the battery (the charge stored can, for practical purposes, be regarded as the amount of charge that can be extracted from the battery in a constant current discharge test over several hours, for example 10 - 20 hours, before the battery voltage drops below a threshold voltage). An input-output pipe 10 provides a pressure drop which varies with fluid flow rate, and consequently models the internal impedance of the battery. The motor/pump 12 serves to distinguish between charging and discharging of the battery.

Advantageously the tank model is represented in a suitably programmed digital computer. However, it will be apparent that the model may be represented in alternative forms and modelled in other data processing systems, for example within an analogue computer. The program for the computer may be held in a, advantageously non-volatile, data carrier.

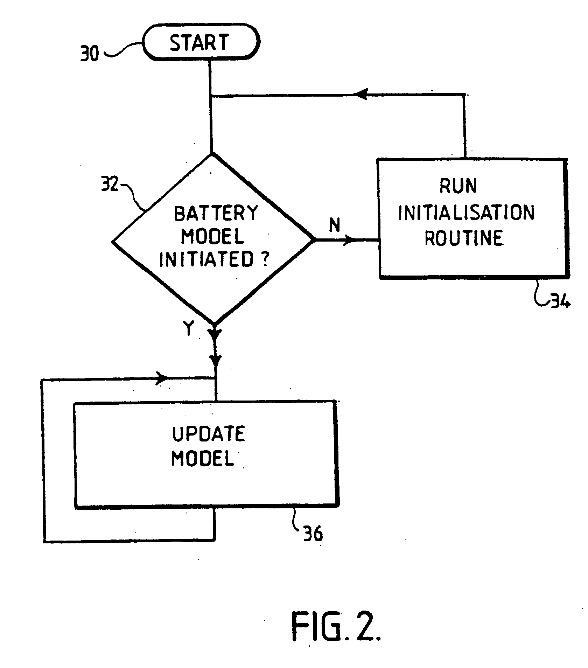

Figure 2 schematically illustrates a flow chart for operation of the model. It will be apparent that the battery being modelled may be changed, for example by an owner of the automobile or during a service. Furthermore, the battery may be disconnected from the automobile while service work is undertaken, thereby causing the power to the data processor implementing the model to be lost. It is therefore necessary to provide a capability to acquire an estimate of the battery condition in an initialisation routine. As shown in Figure 2, following a start 30 which may be caused by power-up or re-initialisation of the data processor. Control is passed to step 32 where a check is made of internal status flags to see if the battery model has been initiated. Control is passed to an initialisation routine 34 if an model has not been started. However, if the model is already running, then control is passed to step 36.

The initialisation routine 34 relies on the fact that the terminal voltage of a battery which is open circuit, or which is only supplying a low current, and which has been left to equilibrialise for a couple of hours (ie no charging or discharging) is representative of the state of charge, SOC, of the battery. If the initialisation routine deduces that the electrical conditions are such that the battery is at or is approaching equilibrium, then it can set the initial SOC estimate and then pass control to step 36 via step 32 in order to run the model. However, if the conditions are such that equilibrium is not being achieved, then the initialisation routine continues to monitor the battery until such time as a SOC estimate can be made.

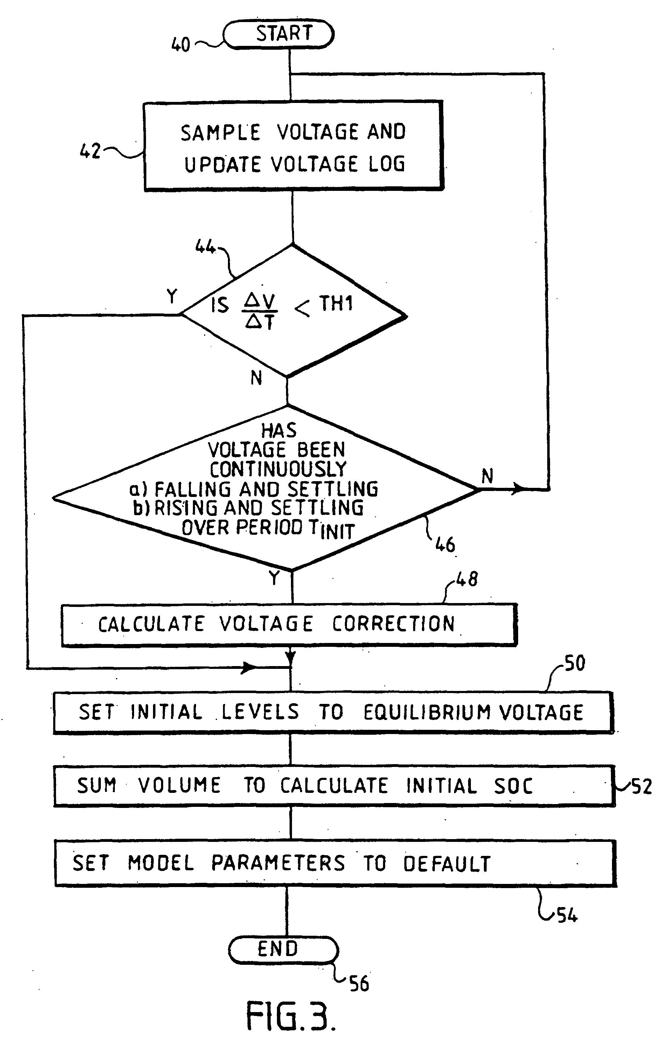

Figure 3 illustrates a flow chart for the initialisation routine, as represented in step 34 of Figure 2. The initialisation routine commences at step 40. Control is then passed to step 42 where the battery voltage is sampled at regular intervals, for example every 15 minutes, and the results are recorded in a voltage log spanning a time period such as the previous two hours or more. Once the voltage log contains a minimum period such as two hours worth of samples, control is passed to step 44 where the voltage change is examined. Step 44 examines the voltage log to check that each voltage sample does not differ from its neighbouring voltage samples by more than a predetermined threshold. Step 44 also examines the voltage log to ensure that the voltage has changed by less than a threshold value $TH_1$ during the previous hour. $TH_1$ corresponds to a voltage change equivalent to a limited charge range such as 2% or less of the total charge capacity of the battery. If the voltage samples are sufficiently close to one another and the overall rate of change is less than $TH_1$, then control is passed to step 50, otherwise control is passed to step 46. If the battery is approaching but not at equilibrium, an allowance for further settling may be calculated. Step 46 re-examines the voltage record to see whether to voltage has been continually falling and settling or continually rising and settling. If either of these conditions is satisfied, control passes to step 48, otherwise control returns to step 42. Step 48 examines the battery voltage which can be assumed to be asymptoting towards an equilibrium value, and estimates the value of the equilibrium by extrapolating the asymptotic behaviour. Control is then passed to step 50 which sets all of the tank levels to the same initial value as determined by the voltage correction estimated at step 48 or by the measured voltage level, if control was passed from step 44 to step 50 directly. Having set the initial tank levels of the tanks $T_1$, $T_2$ and $T_3$ to the same value, the model then uses battery specific coefficients $A_1$, $A_2$ and $A_3$ representing the areas of the tanks for the type of battery being modelled in order to work out the volume of fluid within the model and hence to estimate the initial state of charge. Control is then passed to step 54 which sets other model parameters, such as voltage hysteresis, inter tank flow rates, terminal currents and a gassing voltage correction to default values, which are typically zero. Control then passes to step 56 which is the end of the initialisation routine.

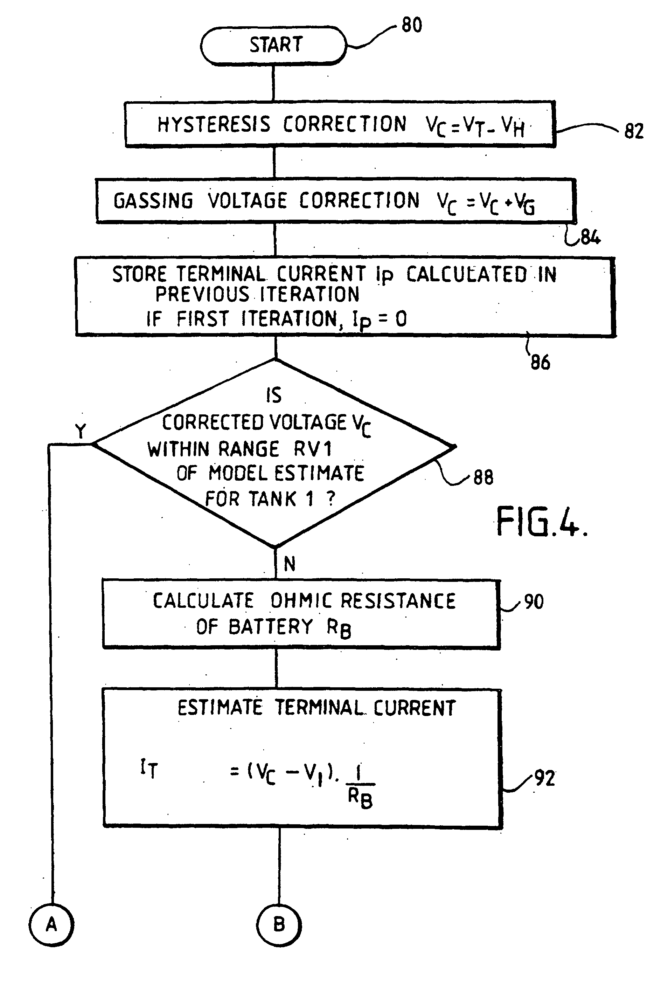

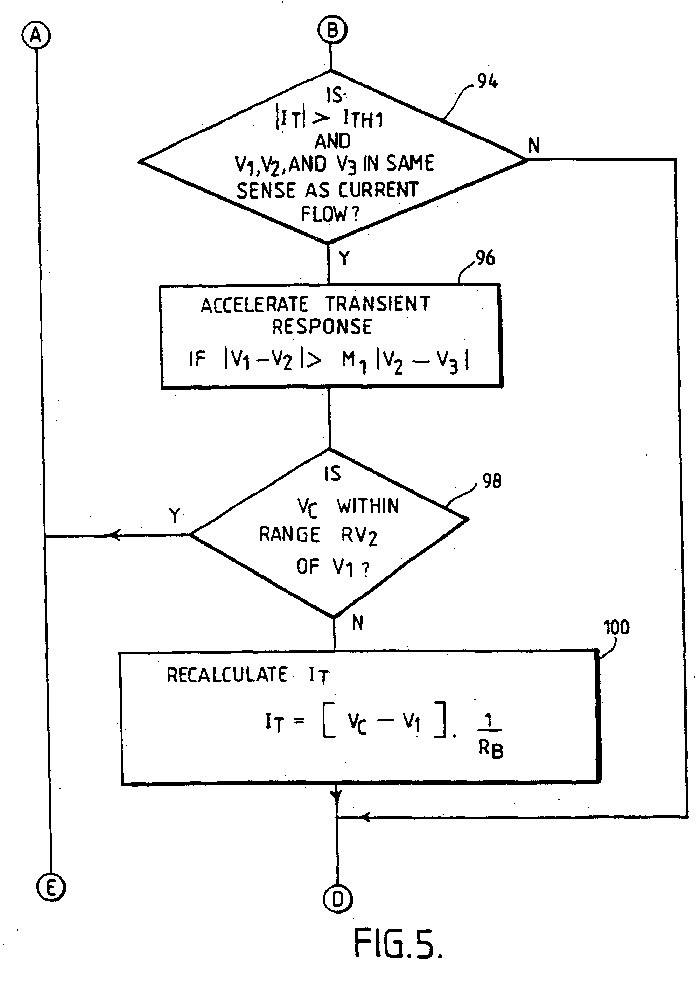

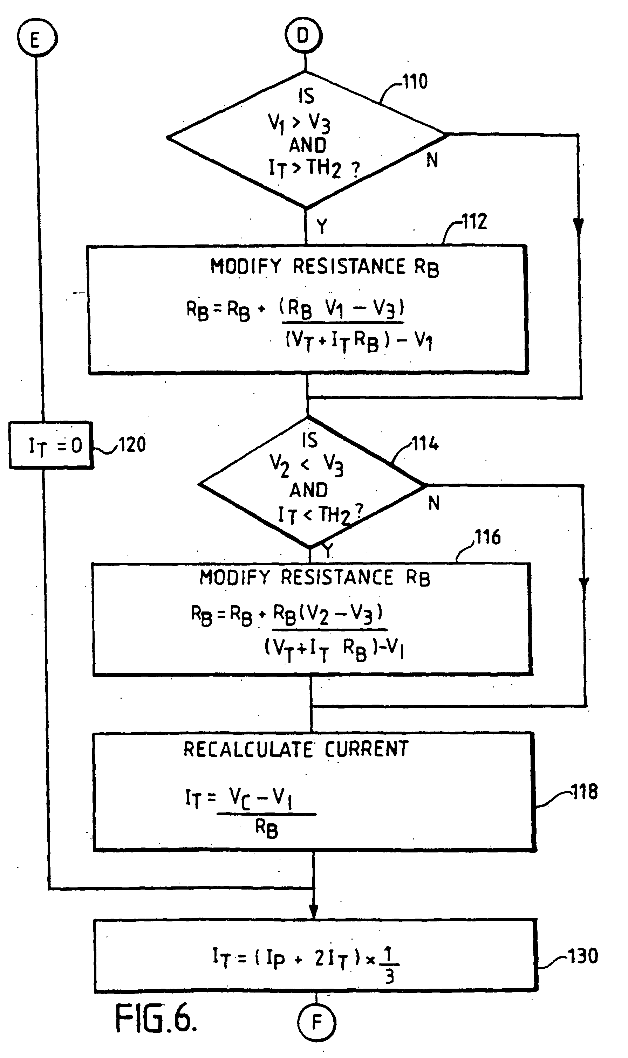

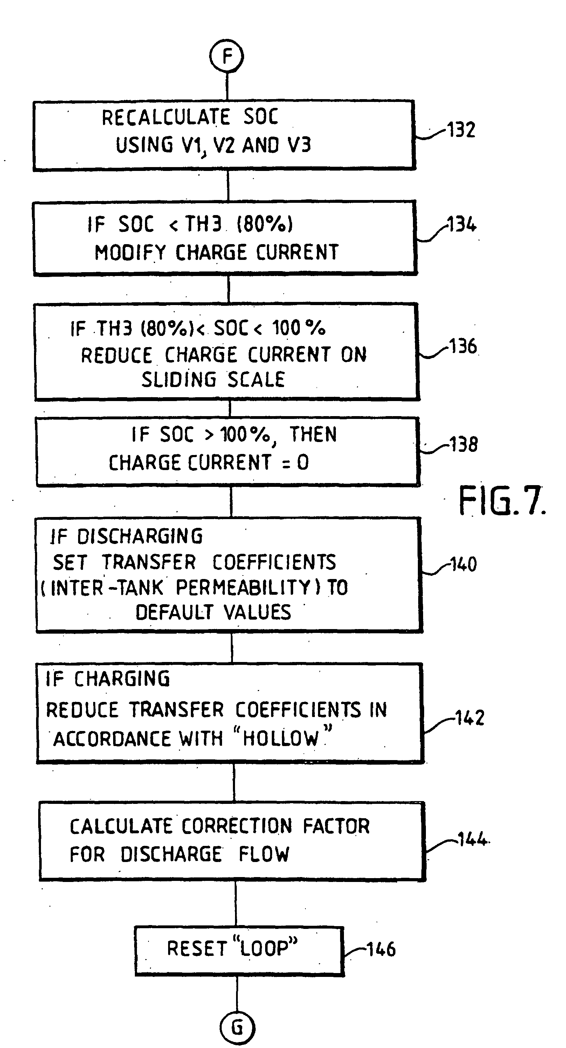

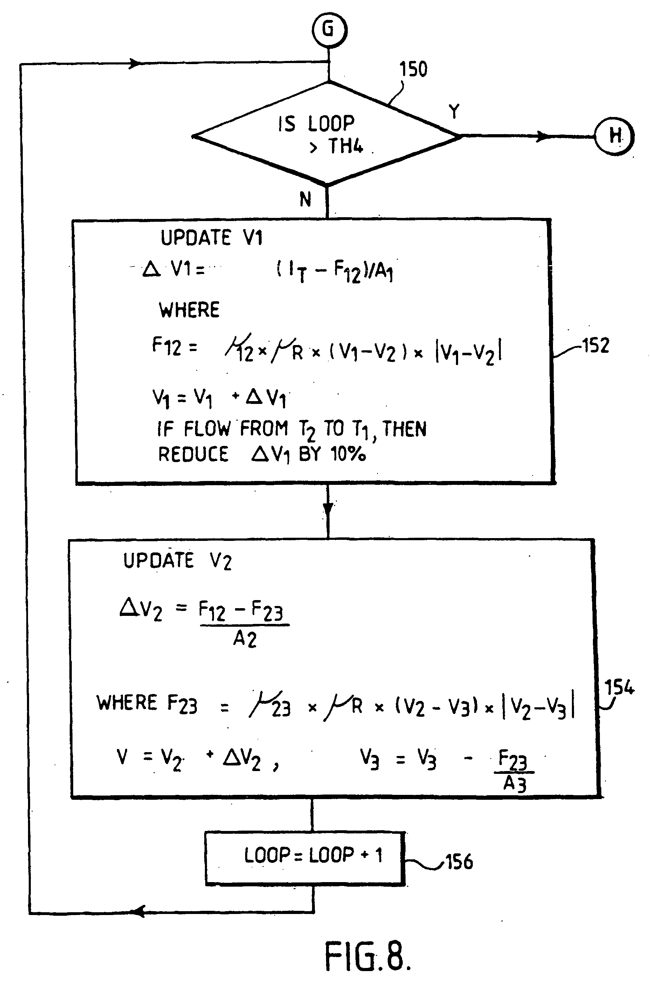

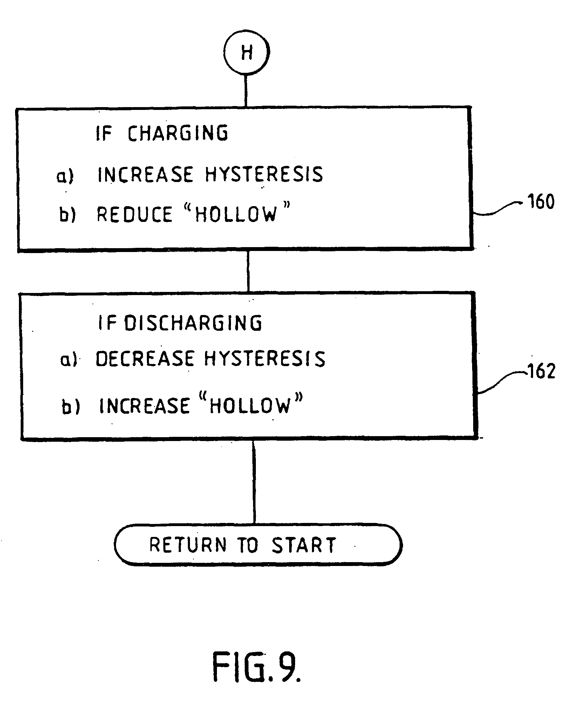

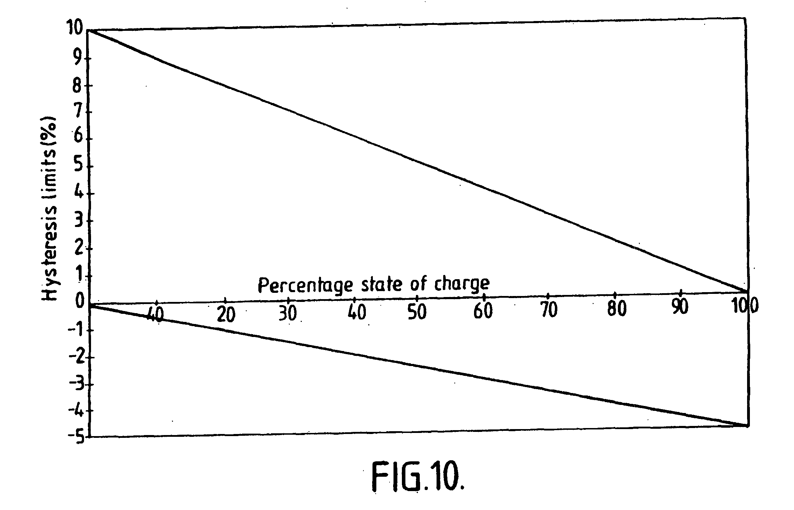

Figures 4 to 9 illustrate the flow chart for the battery model itself. The model commences at step 80, from where control is then passed to step 82 which performs a hysteresis correction. Assuming the measured terminal voltage to be $V_T$, a corrected voltage $V_C$ is formed from the $V_T$-$V_H$, where $V_H$ is calculated as a percentage of the equilibrium voltage range but is limited by the estimate of the state of charge, SOC, in accordance with the graph illustrated in Figure 10. The equilibrium voltage range is (in this example) the difference between the equilibrium voltage at full charge following 3 days of settling and the equilibrium voltage after a constant current discharge test followed by 8 hours of settling.

$V_H$ is single value, whose calculation will be explained later. However, the graph illustrated in Figure 10 sets the limits to the values of $V_H$, and consequently if $V_H$ exceeds this range, it is cut back to the relevant limit as defined in Figure 10. The precise form of Figure 10 is battery specific.

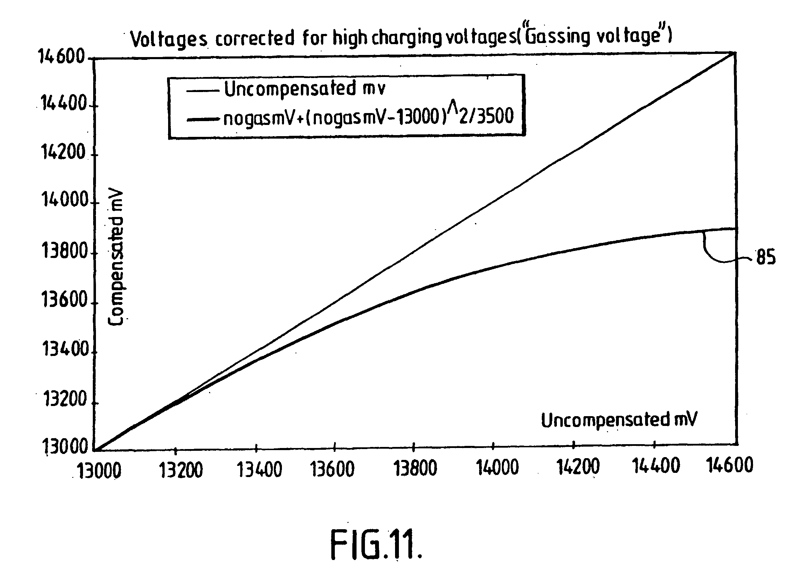

These hysteresis limits reflect the fact a battery following a partial charge or a partial discharge does not accurately return to the open circuit potential which is directly proportional to its state of charge. The introduction of these hysteresis measurements account for this feature of battery chemistry. Control passes from step 82 to step 84 which performs a gassing correction. When a battery is subjected to prolonged charging towards 100% capacity, the terminal voltage gradually rises towards the regulator voltage, e.g. towards 14.6 volts for a 6 cell battery. In these conditions the battery chemistry is altered and the terminal voltage rises above the values which can be accounted for by polarisation, polarisation resistance and ohmic resistance within the battery. Therefore, when the battery model is used to estimate the charging current from the terminal voltage, a gassing correction, as illustrated in Figure 11 may be used to estimate a compensated battery voltage. Thus, for example, looking along line 85 in Figure 11, if the battery terminal voltage is measured at approximately 14.2 volts, then the compensated battery terminal voltage (in this example) corresponds to 13.8 volts. From step 84 control passes to step 86. The estimation of the terminal current, $I_P$, made in the previous cycle of the program is stored at step 86. This value is set to zero for the first cycle.

Control then passes to step 88 where the corrected measured terminal voltage is checked to see if it is within a range $RV_1$ (typically 5mV) of the terminal voltage as estimated by the model, ie the effective level $V_1$ of tank 1, $T_1$. If the corrected voltage $V_C$ is within the range $RV_1$ of the estimated level of tank 1, then control is passed to step 120 which sets the estimated terminal current IT to zero and then passes control to step 130. However, if the corrected voltage is not within the range $RV_1$ of the estimated tank 1 level, and hence the terminal voltage, control is then passed to step 90 which calculates the battery ohmic resistance in accordance with the graph shown in Figure 16. As can be seen, the internal resistance of a battery is typically in the range of 0.01 ohms ($\Omega$) for a state of charge between 60 and 100%. However as the battery becomes increasingly discharged, the internal resistance rises towards 0.03 $\Omega$. Thus the battery resistance $R_B$ is estimated as a function of the state of charge. Control is then passed to step 92 which estimates the terminal current $I_T$ based on the difference between the corrected measured terminal voltage $V_C$ and the model estimate of the zero current terminal voltage $V_1$, as represented by the fluid level in tank $T_1$, divided by the internal resistance $R_B$.

In a embodiment of the present invention, the current $I_T$ is estimated in mA, the voltages $V_C$ and $V_1$ are expressed in mV and the ohmic resistance is expressed 10 millionth of an Ohm.

Control passes from step 92 to step 94 which compares the magnitude of the estimated terminal current with a current threshold $I_{TH1}$, which typically corresponds to a value of 50mA. If the magnitude of the current exceeds the threshold $I_{TH1}$ and the estimated voltage levels $V_1$, $V_2$ and $V_3$ are monitonically increasing or decreasing in a direction consistent with the current flow, then control is passed to step 110, otherwise control is passed to step 96.

Step 96 accelerates the transient response of a the battery in order to reduce the length of time in which the difference between $V_1$ and $V_2$ is more than a coefficient M x the difference between $V_2$ and $V_3$. M typically takes the value of 1.33. If charging, each reduction (which may be expressed in integer terms for computational simplicity) of $V_1$ and $V_3$ is matched by a 4x integer increase in $V_2$. The reverse occurs if discharging. This accelerates the transient response while leaving the total charge unchanged because of the tank ratios (1% + 79% = 4 x 20%). Control then passes to step 98.

Steps 98 and 100 repeat the actions of steps 88 and 92, respectively, and are implemented in case step 96 has altered $V_1$. Thus the estimated terminal voltage $V_1$ of tank 1 is compared with the corrected measured voltage. If the result of the comparison is within a range $RV_2$, typically 5mV, then control is passed to step 120, otherwise control is passed to step 100 which recalculates the terminal current as a difference between the corrected measured voltage and $V_1$, divided by the battery ohmic resistance $R_B$. The recalculated terminal current is then used in place of the previous estimate of terminal current.

From step 100 control is passed to step 110 which determines whether the voltage estimate $V_1$ for tank 1 is greater than the estimate $V_3$ for tank 3, and whether the terminal current is greater than a second threshold $TH_2$, which typically corresponds to 100mA. If both these conditions are satisfied, control is passed to step 112 which makes a modification to the internal battery resistance for charging polarisation, otherwise control is passed to step 114.

The condition $V_1$ greater than $V_3$ corresponds to battery charging and consequently the battery may develop an effective polarisation resistance which inhibits the ingress of charge into the battery. This extra resistance is modelled in step 112 by increasing the estimate of battery resistance $R_B$ by a further amount equal to the product of the ohmic resistance x the difference between the $V_1$ and $V_3$, divided by the difference between the corrected terminal voltage and the estimated voltage $V_1$ of tank 1. Control is then passed to step 114 which checks to see whether the voltage $V_2$ of tank 2 is less than the voltage of tank $V_3$ of tank 3 and whether the modulus of the terminal current discharging the battery is greater than a threshold $TH_2$ (typically 100mA). If both these conditions are satisfied, the internal battery resistance $R_B$ is modified to account for a discharging polarisation at step 116, otherwise control is passed to step 118.

Step 116 modifies the internal resistance $R_B$ of the battery by adding a correction corresponding to the product of the internal resistance multiplied the difference between the voltage $V_2$ of the tank $T_2$ and the voltage $V_3$ of tank 3, divided by the difference between the corrected measured terminal voltage and the estimated terminal voltage $V_1$. Control is then passed to step 118.

Step 118 recalculates the terminal current as a difference between the corrected measured voltage $V_C$ and the estimated tank 1 (zero current) voltage $V_1$, divided by the corrected internal resistance $R_B$. The corrected measured voltage $V_C$ is derived from the actual measured voltage and a correction for the voltage hysteresis $V_H$ and the gassing voltage, $V_G$, if present. Control is passed to step 130 which then modifies the value of estimated terminal current, by partially combining it with the terminal current $I_P$ calculated in the previous cycle of the program (and saved at step 86) in order to damp oscillatory hunting behaviour in the model. From step 130 control then passes to step 132.

Step 132 uses the values of $V_1$, $V_2$ and $V_3$ as at the current iteration, the equilibrium voltage $V_{LOW}$ equivalent to zero stored charge and the equilibrium voltage $V_{HIGH}$ equivalent to a full charge in conjunction with the coefficients $A_1$, $A_2$ and $A_3$ to calculate the % state of charge in the battery using the following equation:

$$\% \text{ state of charge} = \frac{[A_1(V_1 - V_{LOW}) + A_2(V_2 - V_{LOW}) + A_3(V_3 - V_{LOW})]100}{(A_1 + A_2 + A_3)(V_{HIGH} - V_{LOW})}$$

Control is passed to step 134 which compares the estimate of state of charge with a threshold value of $TH_3$, typically set at around 80%. If the state of charge is less than $TH_3$ then the charging current correction is made by multiplying the estimated charging current by correction of coefficient $C_1$ which typically has a value of 0.99 for "maintenance free" batteries. Control is then passed to step 136 which checks to see if the state of charge is greater than threshold $TH_3$ and less than 100%. If so, then the charging current is modified by multiplying by a charge correction coefficient which reduces linearly on a sliding scale. Thus $C_1$ reduces, in this example, from its normal value of 0.99 to 0.79 in a linear fashion as the state of change rises from 80% to 100%. Control then passes to step 138 which checks if the estimated state of charge equals or exceeds 100%, and if so sets the estimated charge current to zero. The charge level corresponding to 100% on an old or degraded battery may be reduced to a lower charge than that represented by 100% when the battery was new. An older battery indicates its reduced charge capacity by means of a lower maximum equilibrium voltage after prolonged charging than that same amount of charge would have caused when the battery was new.

From step 138 control is passed to step 140 which examines the estimated terminal current $I_T$ to see whether a battery is discharging, and if so sets the transfer coefficients $M_{12}$ and $M_{23}$ to their default values. For a model of the type shown in Figure 1 where the charge in the various portions of the battery is represented by fluid level in tanks, and the exchange between tanks is dictated by permeable membranes, the transfer coefficients are herein represented as $\mu_{12}$ and $\mu_{23}$ respectively. Control then progresses to step 142 which, if the battery is charging, modifies the transfer coefficient, ie reduces the permeability in accordance with a factor "hollow" which accounts for the physical observation that a recently discharged battery accepts charge more readily than an equivalent battery having the same state of charge but which has not been recently discharged.

The factor "hollow" is expressed in the same units as the state of charge, ie as a percentage. The initial value of hollow is calculated as a number representing the difference between full charge and the current state of charge.

$$\text{Hollow (\%)} = 100 - \%SOC$$

Alternatively, hollow can be initialised to zero.

When the battery is charging, hollow is reduced in accordance with the following formula:

$$\text{Hollow} = ((\text{Hollow})^2 - (SOC \times \Delta SOC))^{\frac{1}{2}}$$

where

SOC =     state of charge
$\Delta$SOC =     change in state of charge

When the battery is discharging, hollow is increased up to the state of charge in accordance with the following equation:

$$\text{Hollow} = \text{hollow} + \Delta SOC$$

The value of hollow is gradually diminished with time; for example linearly, such that it would reduce from a value of 50% to zero in two weeks. The model may limit the maximum value of hollow to a predetermined limit, for example 50%

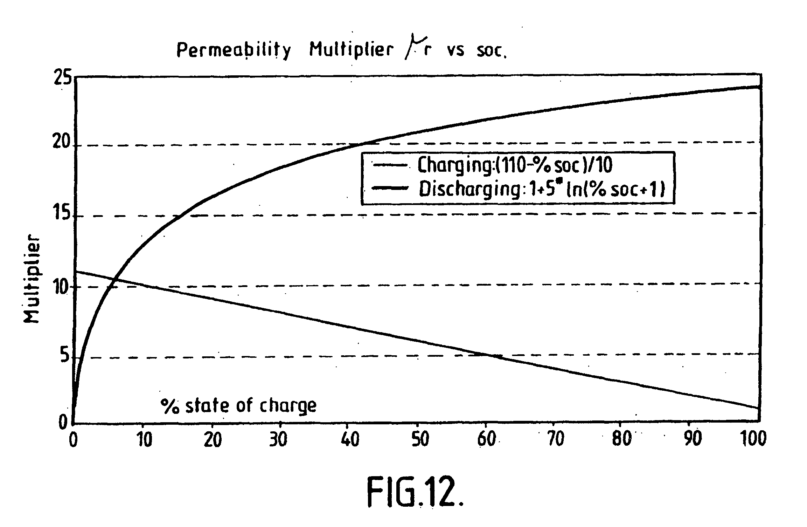

Control then passes to step 144 which calculates a correction factor, in the form of a permeability multiplier $\mu_R$, to be used when the inter-tank flow is an discharging direction. The correction factor $\mu_R$ is a function of a state of charge of the battery and different correction factors are applied in the charging and discharging directions. Figure 12 illustrates a graph of the correction factor $\mu_R$ as a function of state of charge for charging and discharging directions. It will be noted that the correction factor for charging decreases linearly with increasing state of charge. The correction factor in the discharging direction increases in a non linear fashion with increasing state of charge.

Following the calculation of the correction factors, a variable "loop" is reset at step 146. The function of the variable "loop" is to determine that sufficient calculation cycles are made between successive measurement cycles.

Control then progresses to step 150 where the value of loop is compared with a the number of loop iterations required, TH4. If the value of "loop" is greater than TH4 control is passed to step 160, otherwise control is passed to step 152.

Step 152 causes the estimate of fluid in the first tank to be updated. It is assumed that the updates are performed in unit time and consequently a term representing the passage of time can be removed from these equations. The change in the "height of liquid" in tank $T_1$ is estimated from the equation:

$$\Delta V_1 = (I_T - F_{12})/A_1,$$

where $I_T$ is a directional (ie positive or negative) number representing the current through the battery terminals, and

$$F_{12} = \mu_{12} \times \mu_R \times (V_1 - V_2) \times |V_1 - V_2|$$

Thus the term $F_{12}$ is also directional and represents the flow across the permeable membrane $M_{12}$ which is a function of the permeability of the membrane and the product of the difference in height between level 1 and level 2 and the modulus of this height difference. Once the change of level $\Delta V_1$ has been calculated $V_1$ is corrected by this amount.

If the terminal current is in the discharging direction, then the flow from tank 2 to replenish tank 1, is limited to replenish no more than 90% of the depth difference at each iteration in order to prevent oscillatory flow across the membrane in the model.

From step 152, control passes to step 154 which updates the volume in tank V2 by calculating the flow $F_{23}$ across the permeable membrane $M_{23}$. The flow across the permeable membrane between tank 2 and tank 3 is given by an equation:

$$F_{23} = \mu_{23} \times \mu_R \times (V_2 - V_3) \times |V_2 - V_3|$$

The change in the height $\Delta V_2$ is then derived from:

$$\Delta V_2 = (F_{12} - F_{23})/A_2$$

and consequently the values $V_2$ and $V_3$ can be calculated by:

$$V_2 = V_2 + \Delta V_2$$

$$V_3 = V_3 + F_{23}/A_3$$

The value of "loop" in then incremented and control is returned to step 150.

At step 160, a check is made to see if the battery is charging, and if so the value of "hysteresis" is increased and the value of "hollow" is decreased. Control then passes to step 162 which checks to see if the battery is discharging, and if so decreases the value of "hysteresis" and increases the value of "hollow". In an embodiment of the invention in which a twelve second cycle time is used to calculate the battery charge state, the value of hysteresis is modified in accordance with the following equations:

If battery charging and $V_1 > V_2$ then

$$\text{hysteresis} = \text{hysteresis} + (2.5 \times \Delta C)$$

where $\Delta C$ = the increase in % charge in the 12 second cycle time.

If the battery is discharging and $V_2 < V_3$ then

$$\text{hysteresis} = \text{hysteresis} + (0.25 \times \Delta C_D)$$

where $\Delta C_D$ represent the decrease in % charge.

When the battery is charging, positive voltage hysteresis accumulates until the net hysteresis value reaches an upper limit which is inversely proportional to the battery state of charge (Figure 10). Similarly, when the battery is discharging, negative voltage hysteresis accumulates (step 162) until the net hysteresis value reaches a lower limit which is directly proportional to the battery to the battery state of charge (Figure 10).

This voltage hysteresis is expressed as a percentage because it represents the error in the percentage state of charge indicated by the battery equilibrium (settled) voltage. A battery is characterised by a maximum equilibrium voltage which represents 100% state of charge and a lower equilibrium voltage close to the minimum which is taken to represent 0% state of charge, and the range of equilibrium voltage values in between is divided into 100 percentage points. The exact value of the 0% equilibrium voltage depends on the length of the battery calibration discharge, for example 5, 10 or 20 hours, and discharges to below this 0% value are not normally allowed in order to prevent damage to the battery.

The range of hysteresis is limited, for example in accordance with the limits set in Figure 10. The range of hollow is also limited up to the battery state of charge and down to zero.

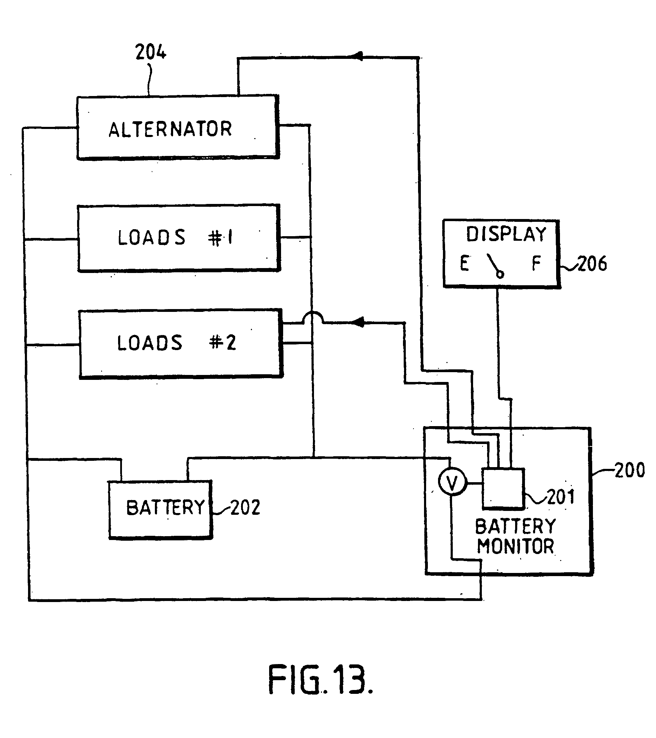

As shown in Figure 13 a battery monitor 200 comprising a voltage measuring device V and a data processor 201 may be provided to measure the voltage across a battery 202 and to use this voltage to estimate the state of charge of the battery. The battery receives charge from an alternator 204 and is discharged via "load #1" which can be taken to represent the essential loads, and "loads #2" which can be taken to represent nonessential loads. The battery monitor 200 has a control line to "loads #2" which can be used to disconnect or reduce the power consumed by one or more of these loads in order to conserve battery life, if necessary. For instance the duty cycle of power supplied to a load may be reduced e.g. by pulsing the power supplied to an electrically heated screen heater, or the cooling provided by the air conditioning may be limited by digital communication to the controller. The battery monitor 200 can also control the alternator 204, for example via a variable ratio pulley, in order to step up the alternator output if necessary during times when the engine speed is low. The battery monitor may also drive a display 206 giving a visual indication of the state of charge of the battery.

Such a battery monitor can also find utility in battery driven vehicles, such as electric cars, milk floats and wheel chairs where it is important to know the state of battery charge in order that the vehicle can be returned to a charge point before power fails or diminishes below an acceptable operating level. Such a battery monitor can also be used to manage battery backed power supplies and power supplies in other vehicles, such as boats, and battery charging systems.

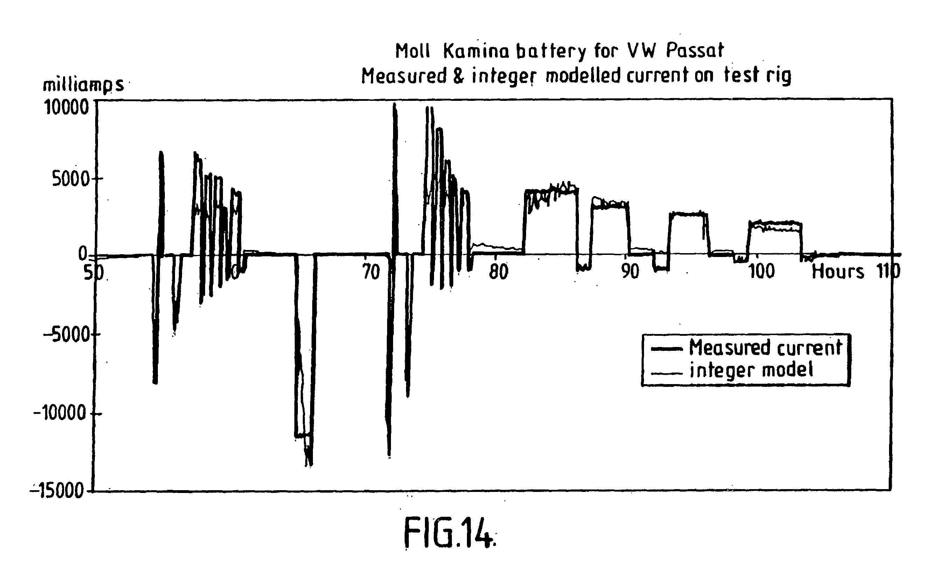

Figure 14 illustrates a comparison between measured currents and currents estimated using the model for a battery made by MOLL KAMINA and intended for a VW Passat automobile. The comparison is made over a time period of 110 hours through various charging and discharging cycles, wherein the maximum current flow is limited to less than 15 amps. As can be seen, the model. is reasonably accurate with the estimated current during long periods of charge or discharge being frequently within one amp or better, while the estimated current within shorter periods of charge or discharge is within a range of 2 amps or so.

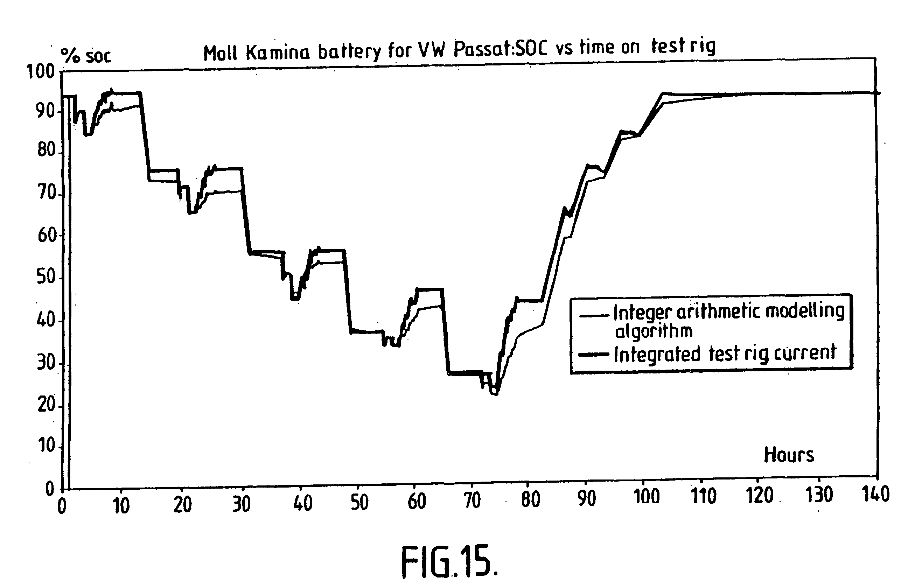

The current flow to and from the battery was integrated on the test rig in order to provide an accurate measurement of the state of charge of the battery. Figure 15 compares the state of charge as measured on the test rig compared to the state of charge as estimated by a model constituting an embodiment of the present invention but using integer arithmetic in order to reduce computational loads. As can be seen, the model estimates compare favourably with the test rig measurements, generally being within 5% of the test rig measurement and tending to be on the conservative side.

It is thus possible to provide a reliable estimate of state of charge of a battery based solely on measurements of the voltage appearing across the battery terminal, such an approach avoids the need to cope with the large dynamic range and precision of current measuring battery state of charge monitoring systems. Furthermore, given that the battery voltage varies over only a range of approximately 10 to 15 volts, the voltage measurement can be resolved to sufficient accuracy using relatively inexpensive operational amplifiers and A to D converters. This compares favourably with the integrator type current measurement systems which needing to resolve currents as low as 5mA and as high as a few hundred amps need to have a dynamic range of approximately 60,000 times.

A data processor performing the modelling of a battery may be provided as an integral part of the battery. This would ensure that the correct modelling coefficients are used for the battery type. The calculated battery state if charge could be communicated from the battery container in a number of ways such as a visual display, an analogue voltage, or a digital signal. The charge level could be transmitted, for example by radio or ultrasound. Such a battery could have an extra terminal through which power is conducted to expendable loads when available but cut-off when battery charge needs to be conserved.

**Claims**

1. A method of estimating the state of charge of a battery (202), comprising monitoring the potential difference across the battery (202), and estimating the charge of the battery, **characterised in that** a data processor (201) is arranged to perform a hysteresis correction which calculates a correction to the potential difference across the battery measured as the battery terminal voltage, and the correction is a function of the estimate of an equilibrium voltage for the battery (202) and the estimate of the state of charge of the battery (202).

2. A method of estimating the condition of a battery (202) as claimed in claim 1, **characterised in that** the battery is represented as at least first ($T_1$) and second ($T_2$) charge storage regions having first and second charge storage capacities or potentials, respectively, and in which the charge transfer between adjacent storage regions is a non-linear function of the difference in the charge stored or the potential between the regions.

3. A method of estimating the condition of a battery (202) as claimed in claim 1 or 2, **characterised in that** the battery is represented as at least first ($T_1$), second ($T_2$) and third ($T_3$) storage regions having first, second and third charge storage capabilities, respectively, and wherein charge can be exchanged between the first ($T_1$) and second ($T_2$) regions via a second exchange path ($M_{12}$) and between the second ($T_2$) and third ($T_3$) regions via a second exchange path ($M_{23}$), the first ($M_{12}$) and second ($M_{23}$) exchange paths exhibiting respective impedances to the exchange of charge between the regions.

4. A method of estimating the condition of a battery as claimed in claim 2 or 3, **characterised in that** the first storage region ($T_1$) is the smallest storage region and it represents the region closest to the terminals of the battery.

5. A method of estimating the condition of a battery as claimed in claim 4, further comprising an exchange path between the first storage region ($T_1$) and the battery terminals.

6. A method of estimating the condition of a battery as claimed in claim 3 or any one of claims 4 or 5 when dependent thereon, **characterised in that** each exchange path has at least one associated coefficient that indicates the ease with which charge can be exchanged along the exchange path.

7. A method of estimating the condition of a battery as claimed in claim 6, **characterised in that** the storage regions are represented by liquid levels in tanks, and the exchange coefficients represent one of the permeability of membranes ($M_{12}$, $M_{23}$) dividing the tanks from one another, the cross section area of pipes connecting the tanks, and the cross section area of orifices connecting the tanks.

8. A method of estimating the condition of a battery as claimed in claim 3 or any one of the claims 4 to 7 when dependent thereon, **characterised in that** the rate of exchange between charge storage regions is a non-linear function of the difference of a first parameter between adjacent tanks.

9. A method of estimating the condition of a battery as claimed in claim 8, **characterised in that**, the first parameter is representative of one of the voltage on charge storage device and a liquid level in a tank ($T_1$, $T_2$, $T_3$) where the volume of liquid in the tank is representative of the charge stored in a charge storage device where said device is represented as a tank.

10. A method of estimating the condition of a battery as claimed in claim 8 or 9, **characterised in that** the non-linear function comprises a square of the difference of the first parameter between adjacent tanks.

11. A method of estimating the condition of a battery as claimed in any one of claims 7 to 10, **characterised in that** respective coefficients are provided for charge flow in different directions between the charge storage regions.

12. A method of estimating the condition of a battery as claimed in any one of the preceding claims, **characterised in that** the magnitude of the correction is limited as a function of the state of charge (soc).

13. A method of estimating the condition of a battery as claimed in any one of the preceding claims **characterised in that** the method further comprises a step of applying a gassing voltage correction to the measured battery voltage.

14. A method of estimating the condition of a battery as claimed in claim 2 or any one of claims 3 to 13 when dependent on claim 2, **characterised by** further including a step of accelerating the rate of charge transfer between storage regions when the potential difference between a pair of the storage regions ($T_1$, $T_2$) exceeds a predetermined proportion of the potential difference between another pair of storage regions ($T_2$, $T_3$).

**15.** A method of estimating the condition of a battery as claimed in any one of the preceding claims, **characterised by** further including an initialisation phase comprising the steps of monitoring the evolution of battery voltage as a function of time, analysing the evolution of battery voltage to determine if the battery is at or approaching an equilibrium condition, extrapolating the evolution of the battery voltage to form an estimate of the equilibrium voltage, and estimating the charge stored in each storage region ($T_1$, $T_2$, $T_3$) based on battery specific coefficients ($A_1$, $A_2$, $A_3$) and the equilibrium voltage.

**16.** A method of estimating the condition of a battery as claimed in any one of the preceding claims, **characterised in that** the method further includes a charge acceptance correction factor which applies a charge current correction as a function of an estimate of state of charge (soc).

**17.** An apparatus for estimating the state of charge of a battery (202), comprising voltage monitoring means for monitoring the potential difference across the battery (202) as the battery terminal voltage, and processing means (201) responsive to the measurement of voltage for estimating the charge of the battery (202), **characterised in that** the data processor (201) is arranged to perform a hysteresis correction which calculates a correction to the measured battery terminal voltage as a function of an estimate of an equilibrium voltage for the battery and an estimate of the state of charge of the battery.

**18.** A computer readable storage medium having a computer program recorded thereon, the program adapted to perform all the steps of the method of claims 1 to 16 when said program is run on a computer.

**Patentansprüche**

**1.** Verfahren zum Abschätzen des Ladezustandes einer Batterie (202), umfassend das Überwachen der Potentialdifferenz an der Batterie (202) und das Abschätzen der Ladung der Batterie, **dadurch gekennzeichnet, dass** ein Datenprozessor (201) dazu eingerichtet ist, eine Hysteresekorrektur durchzuführen, die eine Korrektur für die Potentialdifferenz an der Batterie, gemessen als Batterieklemmenspannung, berechnet, und dass die Korrektur eine Funktion des Schätzwertes einer Gleichgewichtsspannung für die Batterie (202) und der Schätzwert des Ladezustandes der Batterie (202) ist.

**2.** Verfahren zum Abschätzen des Zustandes einer Batterie (202) wie in Anspruch 1 beansprucht, **dadurch gekennzeichnet, dass** die Batterie als zumindest eine erste ($T_1$) und eine zweite ($T_2$) Ladungsspeicherregion mit ersten bzw. zweiten Ladungsspeicherfähigkeiten oder Potentialen dargestellt ist, und wobei der Ladungstransfer zwischen benachbarten Speicherregionen eine nicht-lineare Funktion der Differenz zwischen der in den Regionen gespeicherten Ladung oder dem Potential ist.

**3.** Verfahren zum Abschätzen des Zustandes einer Batterie (202) wie in Anspruch 1 oder 2 beansprucht, **dadurch gekennzeichnet, dass** die Batterie als zumindest erste ($T_1$), zweite ($T_2$) und dritte ($T_3$) Speicherregionen dargestellt ist, die erste, zweite bzw. dritte Ladungsspeicherfähigkeiten besitzen, und worin Ladung zwischen erster ($T_1$) und zweiter ($T_2$) Region über einen ersten Austauschpfad ($M_{12}$) und zwischen der zweiten ($T_2$) und der dritten ($T_3$) Region über einen zweiten Austauschpfad ($M_{23}$) ausgetauscht werden kann, wobei erster ($M_{12}$) und zweiter ($M_{23}$) Austauschpfad betreffende Impedanzen für den Austausch von Ladung zwischen den Regionen aufweisen.

**4.** Verfahren zum Abschätzen des Zustandes einer Batterie wie in Anspruch 2 oder 3 beansprucht, **dadurch gekennzeichnet, dass** die erste Speicherregion ($T_1$) die kleinste Speicherregion ist und dass sie die den Anschlüssen der Batterie nächstgelegene Region darstellt.

**5.** Verfahren zum Abschätzen des Zustandes einer Batterie wie in Anspruch 4 beansprucht, ferner einen Austauschpfad zwischen der ersten Speicherregion ($T_1$) und den Batterieanschlüssen aufweisend.

**6.** Verfahren zum Abschätzen des Zustandes einer Batterie wie in Anspruch 3 oder einem der davon abhängigen Ansprüche 4 oder 5 beansprucht, **dadurch gekennzeichnet, dass** jeder Austauschpfad zumindest einen zugehörigen Koeffizienten besitzt, der die Leichtigkeit angibt, mit der Ladung entlang des Austauschpfades ausgetauscht werden kann.

7. Verfahren zum Abschätzen des Zustandes einer Batterie wie in Anspruch 6 beansprucht, **dadurch gekennzeichnet, dass** die Speicherregionen durch Flüssigkeitspegel in Behältern dargestellt sind und die Austauschkoeffizienten die Permeabilität von Membranen ($M_{12}$, $M_{23}$), die die Behälter voneinander trennen, oder die Querschnittsfläche von Rohren, die die Behälter verbinden, oder die Querschnittsfläche von die Behälter verbindenden Öffnungen darstellen.

8. Verfahren zum Abschätzen des Zustandes einer Batterie wie in Anspruch 3 oder einem der hiervon abhängigen Ansprüche 4 bis 7 beansprucht, **dadurch gekennzeichnet, dass** die Rate des Austausches zwischen Ladungspeicherregionen eine nicht-lineare Funktion der Differenz eines ersten Parameters zwischen benachbarten Behältern ist.

9. Verfahren zum Abschätzen des Zustandes einer Batterie wie in Anspruch 8 beansprucht, **dadurch gekennzeichnet, dass** der erste Parameter die Spannung an der Ladungsspeichervorrichtung oder einen Flüssigkeitspegel in einem Behälter ($T_1$, $T_2$, $T_3$) darstellt, wenn das Volumen der Flüssigkeit in dem Behälter die Ladung darstellt, die in einer Ladungsspeichervorrichtung gespeichert ist, wenn genannte Vorrichtung als ein Behälter dargestellt ist.

10. Verfahren zum Abschätzen des Zustandes einer Batterie wie in Anspruch 8 oder 9 beansprucht, **dadurch gekennzeichnet, dass** die nicht-lineare Funktion ein Quadrat der Differenz des ersten Parameters zwischen benachbarten Behältern umfaßt.

11. Verfahren zum Abschätzen des Zustandes einer Batterie wie in einem der Ansprüche 7 bis 10 beansprucht, **dadurch gekennzeichnet, dass** betreffende Koeffizienten für das Fliessen von Ladung in verschiedenen Richtungen zwischen den Ladungsspeicherregionen vorgesehen sind.

12. Verfahren zum Abschätzen des Zustandes einer Batterie wie in einem der vorausgehenden Ansprüche beansprucht, **dadurch gekennzeichnet, dass** die Größe der Korrektur als Funktion des Ladezustandes (soc) begrenzt ist.

13. Verfahren zum Abschätzen des Zustandes einer Batterie wie in einem der vorausgehenden Ansprüche beansprucht, **dadurch gekennzeichnet, dass** das Verfahren ferner einen Schritt des Anwendens einer Korrektur der Gasungsspannung auf die gemessene Batteriespannung umfaßt.

14. Verfahren zum Abschätzen des Zustandes einer Batterie wie in Anspruch 2 oder einem der von Anspruch 2 abhängigen Ansprüche 3 bis 13 beansprucht, **dadurch gekennzeichnet, dass** es ferner einen Schritt des Beschleunigens der Rate des Ladungstransfers zwischen Speicherregionen beinhaltet, wenn die Potentialdifferenz zwischen einem Paar der Speicherregionen ($T_1$, $T_2$) einen vorbestimmten Teil der Potentialdifferenz zwischen einem weiteren Paar Speicherregionen ($T_2$, $T_3$) übersteigt.

15. Verfahren zum Abschätzen des Zustandes einer Batterie wie in einem der vorausgehenden Ansprüche beansprucht, **dadurch gekennzeichnet, dass** es ferner eine Initialisierungsphase beinhaltet, die die Schritte des Überwachens der Entwicklung von Batteriespannung als Funktion der Zeit, das Untersuchen der Entwicklung von Batteriespannung, um zu ermitteln, ob sich die Batterie im Gleichgewichtszustand oder in Annäherung an diesen befindet, das Extrapolieren der Entwicklung der Batteriespannung, um einen Schätzwert der Gleichgewichtsspannung zu bilden, sowie das Abschätzen der in jeder Speicherregion ($T_1$, $T_2$, $T_3$) gespeicherten Ladung aufgrund batteriespezifischer Koeffizienten ($A_1$, $A_2$, $A_3$,) und der Gleichgewichtsspannung umfaßt.

16. Verfahren zum Abschätzen des Zustandes einer Batterie wie in einem der vorausgehenden Ansprüche beansprucht, **dadurch gekennzeichnet, dass** das Verfahren ferner einen Ladungsaufnahme-Korrekturfaktor beinhaltet, der eine Ladestromkorrektur als Funktion eines Schätzwertes des Ladezustandes (soc) benutzt.

17. Vorrichtung zum Abschätzen des Ladezustandes einer Batterie (202), mit einem Spannungsüberwachungsmittel, um die Potentialdifferenz an der Batterie als Batterieklemmenspannung zu überwachen, und mit einem Prozessormittel (201), das auf die Spannungsmessung anspricht, um die Ladung der Batterie (202) abzuschätzen, **dadurch gekennzeichnet, dass** der Datenprozessor (201) dazu eingerichtet ist, um eine Hysteresekorrektur durchzuführen, die eine Korrektur für die gemessene Batterieklemmenspannung als Funktion eines Schätzwertes einer Gleichgewichtsspannung für die Batterie und einen Schätzwert des Ladezustandes der Batterie berechnet.

18. Computerlesbares Speichermedium mit einem auf diesem aufgezeichnetem Computerprogramm, welches Programm dazu eingerichtet ist, sämtliche der Schritte des Verfahrens der Ansprüche 1 bis 16 auszuführen, wenn das genannte Programm auf einem Computer ausgeführt wird.

**Revendications**

1. Procédé pour estimer l'état de charge d'une batterie (202), comprenant la surveillance de la différence de potentiel à travers la batterie (202) et l'estimation de la charge de la batterie, **caractérisé en ce qu'**un processeur de données (201) est arrangé pour exécuter une correction d'hystérésis qui calcule une correction à la différence de potentiel à travers la batterie, mesurée comme tension aux bornes de la batterie, et la correction est une fonction de l'estimation d'une tension d'équilibre pour la batterie (202) et de l'estimation de l'état de charge de la batterie (202).

2. Procédé pour estimer l'état d'une batterie (202) selon la revendication 1, **caractérisé en ce que** la batterie est représentée par au moins des première ($T_1$) et deuxième ($T_2$) régions de stockage de charge ayant des première et deuxième capacités de stockage de charge ou potentiels, respectivement, et dans lequel le transfert de charge entre les régions de stockage adjacentes est une fonction non linéaire de la différence de charge stockée ou de potentiel entre les régions.

3. Procédé pour estimer l'état d'une batterie (202) selon la revendication 1 ou 2, **caractérisé en ce que** la batterie est représentée par au moins des première ($T_1$), deuxième ($T_2$) et troisième ($T_3$) régions de stockage ayant des première, deuxième et troisième capacités de stockage de charge, respectivement, et dans lequel une charge peut être échangée entre les première ($T_1$) et deuxième ($T_2$) régions via une deuxième voie d'échange ($M_{12}$) et entre les deuxième ($T_2$) et troisième ($T_3$) régions via une deuxième voie d'échange ($M_{23}$), les première ($M_{12}$) et deuxième ($M_{23}$) voies d'échange montrant des impédances respectives à l'échange de charge entre les régions.

4. Procédé pour estimer l'état d'une batterie selon la revendication 2 ou 3, **caractérisé en ce que** la première région de stockage ($T_1$) est la région de stockage la plus petite et elle représente la région la plus proche des bornes de la batterie.

5. Procédé pour estimer l'état d'une batterie selon la revendication 4, comprenant en outre une voie d'échange entre la première région de stockage ($T_1$) et les bornes de la batterie.

6. Procédé pour estimer l'état d'une batterie selon la revendication 3 ou l'une quelconque des revendications 4 ou 5 lorsqu'elle en dépend, **caractérisé en ce que** chaque voie d'échange a au moins un coefficient associé qui indique la facilité avec laquelle la charge peut être échangée le long de la voie d'échange.

7. Procédé pour estimer l'état d'une batterie selon la revendication 6, **caractérisé en ce que** les régions de stockage sont représentées par des niveaux de liquide dans des réservoirs, et les coefficients d'échange représentent soit la perméabilité des membranes ($M_{12}$, $M_{23}$) divisant les réservoirs l'un de l'autre, soit l'aire de section en coupe des conduits raccordant les réservoirs, soit l'aire de section en coupe des orifices raccordant les réservoirs.

8. Procédé pour estimer l'état d'une batterie selon la revendication 3 ou l'une quelconque des revendications 4 à 7 lorsqu'elle en dépend, **caractérisé en ce que** le débit d'échange entre les régions de stockage de charge est une fonction non linéaire de la différence d'un premier paramètre entre des réservoirs adjacents.

9. Procédé pour estimer l'état d'une batterie selon la revendication 8, **caractérisé en ce que** le premier paramètre est représentatif soit de la tension sur le dispositif de stockage de charge, soit d'un niveau de liquide dans un réservoir ($T_1$, $T_2$, $T_3$), où le volume de liquide dans le réservoir est représentatif de la charge stockée dans un dispositif de stockage de charge où ledit dispositif est représenté par un réservoir.

10. Procédé pour estimer l'état d'une batterie selon la revendication 8 ou 9, **caractérisé en ce que** la fonction non linéaire comprend un carré de la différence du premier paramètre entre des réservoirs adjacents.

11. Procédé pour estimer l'état d'une batterie selon l'une quelconque des revendications 7 à 10, **caractérisé en ce que** des coefficients respectifs sont prévus pour le flux de charge dans différentes directions entre les régions de stockage de charge.

**12.** Procédé pour estimer l'état d'une batterie selon l'une quelconque des revendications précédentes, **caractérisé en ce que** la grandeur de la correction est limitée en fonction de l'état de charge (edc).

**13.** Procédé pour estimer l'état d'une batterie selon l'une quelconque des revendications précédentes, **caractérisé en ce que** le procédé comprend en outre une étape d'application d'une correction de tension de gazage à la tension mesurée de la batterie.

**14.** Procédé pour estimer l'état d'une batterie selon la revendication 2 ou l'une quelconque des revendications 3 à 13 lorsqu'elle dépend de la revendication 2, **caractérisé en ce qu'**il comprend en outre une étape consistant à accélérer le débit de transfert de charge entre les régions de stockage lorsque la différence de potentiel entre une paire des régions de stockage ($T_1$, $T_2$) excède une proportion prédéterminée de la différence de potentiel entre une autre paire de régions de stockage ($T_2$, $T_3$).

**15.** Procédé pour estimer l'état d'une batterie selon l'une quelconque des revendications précédentes, **caractérisé en ce qu'**il comprend en outre une phase d'initialisation comprenant les étapes consistant à surveiller l'évolution de la tension de la batterie en fonction du temps, analyser l'évolution de la tension de la batterie pour déterminer si la batterie est dans une situation d'équilibre ou s'en approche, extrapoler l'évolution de la tension de la batterie pour former une estimation de la tension d'équilibre et estimer la charge stockée dans chaque région de stockage ($T_1$, $T_2$, $T_3$) sur la base de coefficients spécifiques de la batterie ($A_1$, $A_2$, $A_3$) et de la tension d'équilibre.

**16.** Procédé pour estimer l'état d'une batterie selon l'une quelconque des revendications précédentes, **caractérisé en ce que** le procédé comprend en outre un facteur de correction d'admission de charge qui applique une correction de courant de charge en fonction d'une estimation de l'état de charge (edc).

**17.** Appareil pour estimer l'état de charge d'une batterie (202), comprenant des moyens de surveillance de tension pour surveiller la différence de potentiel à travers la batterie (202) en tant que tension aux bornes de la batterie, et des moyens de traitement (201) sensibles à la mesure de la tension pour estimer la charge de la batterie (202), **caractérisé en ce que** le processeur de données (201) est arrangé pour exécuter une correction d'hystérésis qui calcule une correction à la tension aux bornes mesurée de la batterie en fonction d'une estimation d'une tension d'équilibre pour la batterie et d'une estimation de l'état de charge de la batterie.

**18.** Support de stockage lisible sur ordinateur ayant un programme d'ordinateur enregistré dessus, le programme étant adapté pour exécuter toutes les étapes du procédé des revendications 1 à 16 lorsque ledit programme est exécuté sur un ordinateur.

M23    M23

Level 3

Level 2

Level 1

10

12

Motor/pump    T₁    T₂    T₃

# FIG.1.

ohms.    Increase in battery ohmic resistance per 0.01 ohms at low charge levels

0.03

0.025

if (soc < 59) ohms = ohms + ohms*(60−% soc)^2/2000

0.02

0.015

0.01

0.005

0

0    10    20    30    40    50    60    70    80    90    100    % soc

# FIG.16.

FIG. 2.

40 — START

42 — SAMPLE VOLTAGE AND UPDATE VOLTAGE LOG

44 — Y ← IS $\frac{\Delta V}{\Delta T}$ < TH1

N

46 — HAS VOLTAGE BEEN CONTINUOUSLY a) FALLING AND SETTLING b) RISING AND SETTLING OVER PERIOD $T_{INIT}$ → N

Y

48 — CALCULATE VOLTAGE CORRECTION

50 — SET INITIAL LEVELS TO EQUILIBRIUM VOLTAGE

52 — SUM VOLUME TO CALCULATE INITIAL SOC

54 — SET MODEL PARAMETERS TO DEFAULT

56 — END

FIG.3.

START — 80

HYSTERESIS CORRECTION $V_C = V_T - V_H$ — 82

GASSING VOLTAGE CORRECTION $V_C = V_C + V_G$ — 84

STORE TERMINAL CURRENT $I_p$ CALCULATED IN
PREVIOUS ITERATION
IF FIRST ITERATION, $I_p = 0$ — 86

IS
CORRECTED VOLTAGE $V_C$
WITHIN RANGE RV1
OF MODEL ESTIMATE
FOR TANK 1 ? — 88

Y

N

CALCULATE OHMIC RESISTANCE
OF BATTERY $R_B$ — 90

ESTIMATE TERMINAL CURRENT

$$I_T = (V_C - V_I) \cdot \frac{1}{R_B}$$ — 92

A

B

FIG.4.

17

FIG.5.

FIG.6.

```
                    ( F )
                      |
   ┌──────────────────────────────────┐
   │      RECALCULATE SOC             │
   │      USING V1, V2 AND V3         │──── 132
   └──────────────────────────────────┘
                      |
   ┌──────────────────────────────────┐
   │   IF SOC < TH3 (80%)            │
   │   MODIFY CHARGE CURRENT          │──── 134
   └──────────────────────────────────┘
                      |
   ┌──────────────────────────────────┐
   │  IF TH3 (80%)< SOC < 100%       │
   │  REDUCE CHARGE CURRENT ON        │──── 136
   │  SLIDING SCALE                   │
   └──────────────────────────────────┘
                      |
   ┌──────────────────────────────────┐
   │   IF SOC > 100%, THEN           │
   │   CHARGE CURRENT = 0             │──── 138
   └──────────────────────────────────┘
                      |
   ┌──────────────────────────────────┐
   │ IF DISCHARGING                   │
   │  SET TRANSFER COEFFICIENTS       │
   │ (INTER-TANK PERMEABILITY) TO     │──── 140
   │   DEFAULT VALUES                 │
   └──────────────────────────────────┘
                      |
   ┌──────────────────────────────────┐
   │ IF CHARGING                      │
   │ REDUCE TRANSFER COEFFICIENTS IN  │──── 142
   │ ACCORDANCE WITH "HOLLOW"         │
   └──────────────────────────────────┘
                      |
   ┌──────────────────────────────────┐
   │ CALCULATE CORRECTION FACTOR      │
   │ FOR DISCHARGE FLOW               │──── 144
   └──────────────────────────────────┘
                      |
        ┌─────────────────────────┐
        │    RESET "LOOP"         │──── 146
        └─────────────────────────┘
                      |
                    ( G )
```

FIG.7.

G

150

IS LOOP
> TH4

Y → H

N

UPDATE V1

$\Delta V1 = (I_T - F_{12})/A_1$

WHERE

$F_{12} = \mu_{12} \times \mu_R \times (V_1 - V_2) \times |V_1 - V_2|$

$V_1 = V_1 + \Delta V_1$

IF FLOW FROM $T_2$ TO $T_1$, THEN
REDUCE $\Delta V_1$ BY 10%

152

UPDATE V2

$\Delta V_2 = \dfrac{F_{12} - F_{23}}{A_2}$

WHERE $F_{23} = \mu_{23} \times \mu_R \times (V_2 - V_3) \times |V_2 - V_3|$

$V = V_2 + \Delta V_2, \qquad V_3 = V_3 - \dfrac{F_{23}}{A_3}$

154

LOOP = LOOP + 1    156

FIG.8.

H

IF CHARGING

a) INCREASE HYSTERESIS

b) REDUCE "HOLLOW"

— 160

IF DISCHARGING

a) DECREASE HYSTERESIS

b) INCREASE "HOLLOW"

—162

RETURN TO START

FIG.9.

FIG.10.

Voltages corrected for high charging voltages("Gassing voltage")

FIG.11.

EP 1 097 388 B1

Permeability Multiplier $\mu_r$ vs soc.

Charging: (110-% soc)/10
Discharging: 1+5* ln(% soc+1)

% state of charge

FIG.12.

EP 1 097 388 B1

FIG. 13.

Moll Kamina battery for VW Passat
Measured & integer modelled current on test rig

FIG.14.

EP 1 097 388 B1

FIG.15.

Moll Kamina battery for VW Passat:SOC vs time on test rig

(Legend)
Integer arithmetic modelling algorithm
Integrated test rig current

Hours

% soc

EP 1 097 388 B1